# EUROPEAN PATENT APPLICATION

(11) **EP 1 624 483 A1**
(43) Date of publication of application: **08.02.2006**
(21) Application number: 04728415.3
(22) Date of filing: 20.04.2004
(51) Int. Cl.: H01L 21/66, G01N 21/956

(54) **SEMICONDUCTOR MANUFACTURING SYSTEM**

(30) Priority: 22.04.2003 JP 2003117307
(71) Applicant: TOKYO ELECTRON LIMITED, Minato-ku, Tokyo 107-8481 (JP)
(72) Inventor: YATSUGAKE, Y., Tokyo Electron Ltd, Minato-ku, Tokyo 1078481 (JP); KATO, H., Tokyo Electron Ltd, Minato-ku, Tokyo 1078481 (JP); YASUHARA, M., Tokyo Electron Ltd, Minato-ku, Tokyo 1078481 (JP); IRIE, T., Tokyo Electron Ltd, Minato-ku, Tokyo 1078481 (JP)
(74) Representative: Liesegang, Eva
(86) International application number: PCT/JP2004/005633
(87) International publication number: WO 2004/095566

(57) **Abstract**

The present invention provides a system capable of automatically making a diagnosis of a semiconductor device manufacturing apparatus, based on a result of particle detection on a substrate such as a semiconductor wafer. In one preferred embodiment, the surface of the wafer is divided into square-shaped minute areas of 0.1 mm to 0.5 mm, and existence of particles in each minute area is inspected. Based on the inspection result, data, in which existence of particles in each minute area is correlated with the address thereof, is created. The surface of the wafer is divided into several tens to several hundreds of evaluation areas. A binarized data is assigned to each evaluation area, and is determined based on the fact that the number of the minute areas in which particles are detected included in the evaluation area is larger, or not larger than a predetermined reference value. A correspondence table, showing the relationship between binarized data arrangements and the causes of particle adhesion, which is made based on empirical rules or experimental results, is prepared. By applying the binarized data made based on the inspection result to the correspondence table, the cause of particle adhesion can be identified.

## Description

### TECHNICAL FIELD

The present invention relates to a semiconductor device manufacturing system having functions of detecting particles adhered to a substrate, such as a semiconductor wafer, which has been subjected to a predetermined treatment by a semiconductor device manufacturing apparatus, and of determining the cause of particle adhesion based on the detection result.

### BACKGROUND ART

Semiconductor device manufacturing apparatuses used in a series of treatment steps for manufacturing a semiconductor integrated circuit includes, for example, a film-deposition apparatus, an etching apparatus, a coating and developing apparatus for applying a resist to a wafer and developing the same, and a cleaning apparatus for cleaning a wafer. When a malfunction, resulting in an undesirable treatment result (i.e., adhesion of particles), occurs in one semiconductor device manufacturing apparatus, the succeeding treatment steps become useless. Thus, conditions of the respective apparatuses must be constantly monitored.

In semiconductor device manufacturing processes, an acceptable level of particles is very low. Particles may be easily generated due to various reasons, such as deterioration of mechanical component parts, deterioration of a filter unit for air-conditioning in an apparatus, and scattering of a treatment product such as a thin film. Thus, in order to monitor generation of particles due to a malfunction of an apparatus, inspection of particle-adhesion state of wafers is inevitably performed in all sorts of apparatuses.

A particle inspecting device detects particles based on the fact that intensity of a scattered light, which is generated when irradiating a light on a surface of a wafer, varies depending on the particle size. The particle inspecting device scans the surface of the wafer by rotating the wafer and moving a spot of a light such as a laser beam in a radial direction of the wafer to inspect the particle-adhesion state on the wafer.

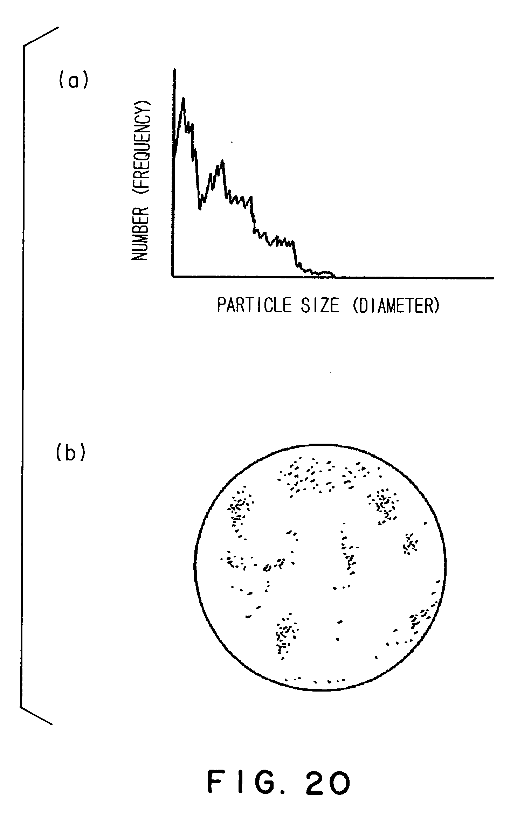

One of known methods of inspecting particles is as follows. A surface of a wafer is divided into plural minute, substantially square-shaped areas (in more detail, sector regions) 0.1 mm to 0.5 mm on a side. Addresses are assigned to the minute areas to identify their respective positions. Representative values, each representing the inspection result of each minute area, are arranged in a two-dimensional array according to the addresses of the respective minute areas, and are often handled as two-dimensional image data (see Fig. 20(b)) as described later. Thus, each minute area is called "pixel", and data in which the representative values of the pixels are correlated with their individual addresses are called "pixel data". The terms "pixel" and "pixel data" are used to mean those defined above throughout the specification.

The particle inspecting device includes a laser beam irradiating unit that sequentially irradiates the plural pixels with laser beams. Each pixel is irradiated with a laser beam having a spot size of 60 µm in diameter for plural times, e.g., ten times, while the irradiated position is shifted. An area irradiated with a laser beam by a single light irradiation is called "spot area". In order not to leave, within a pixel, areas which are not irradiated with a laser beam, each spot area is overlapped with an adjacent spot area. The planar area (dimension) of the overlapped portion is half the spot size of the laser beam. In this manner, ten values of the scattered light intensity are obtained in each pixel. An inspecting computer stores a relationship between the scattered light intensity and the particle size. The computer calculates the particle size based on the maximum value of the scattered light intensity among the ten values. The calculated particle size is handled as a representative particle size of the pixel.

By similarly inspecting all the pixels to obtain data, a graph can be made which shows the frequency of appearance of particles with respect to the particle size (see Fig. 20(a)). By making a graph similar to Fig. 20(a) in which the difference between the frequency of appearance of particles in a wafer after treatment and that in the wafer before treatment is plotted with respect to the particle size, particles adhered to the wafer due to the treatment can be seen. Since addresses are assigned to the respective pixels, a two-dimensional map, in which pixels are distinguished by using different colors based on the representative particle size of each pixel, can be made. Fig. 20(b) schematically shows such a map.

Based on the inspection result processed as described above, an operator can monitor an occurrence of a malfunction in the semiconductor device manufacturing apparatus, determine the cause of particle generation, and perform maintenance on the semiconductor device manufacturing apparatus on demand.

If the surface of a 12-inch wafer is divided into a plurality of minute pixels, the number of pixels is no fewer than some hundred thousands. In the computer used with the semiconductor device manufacturing apparatus, the performance of the processor is poor and a memory capacity is small. Thus, it is practically very difficult for the computer used with the semiconductor device manufacturing apparatus to execute a calculation for estimating the cause of particle generation by using such vast amounts of inspection data as they are. It is also very difficult to transfer such vast amounts of inspection data to another computer having a high computing power. Therefore, in practice, an operator makes a diagnosis based on the inspection result which is output from the particle inspecting device.

However, only a highly skilled operator can determine the cause of particle adhesion based on the particle-adhesion state. Thus, in a case where such a highly skilled operator is not available, the cause must be investigated by trial and error, which is a heavy burden. In a case of requesting maintenance to the manufacturer of the semiconductor device manufacturing apparatus, the user must await the arrival of a service person. In addition, depending on the inspection result, the service person must return to his or her company to pick-up some repair instruments. In this case as well, the user must bear a heavy financial and temporal burden.

An employment of an automatic operation system has been recently promoted. In this automatic operation system, a computer analyzes the detection results obtained by various sensors arranged in a semiconductor device manufacturing apparatus. The treatment parameters are changed or the apparatus is cleaned based on the analysis. However, as described above, since only a highly skilled operator can determine the cause of particle adhesion, it is impossible to provide the automatic operation system with a function of eliminating the cause of particle generation.

### SUMMARY OF THE INVENTION

The present invention has been made in view of the foregoing context. An object of the present invention is to provide a semiconductor device manufacturing system capable of automatically making a diagnosis of a semiconductor device manufacturing apparatus based on a particle inspection result.

A semiconductor device manufacturing system according to the present invention includes: a semiconductor device manufacturing apparatus; a particle detecting part that detects particles adhered to a substrate which has been subjected to a predetermined treatment by the semiconductor device manufacturing apparatus; an evaluation data creating part that creates evaluation data for evaluating a state of particle adhesion based on a detection result of the particle detecting part; a storage part that stores previously created correspondence data relating to a correspondence between the evaluation data and causes of particle adhesion to the substrate; and a determining part that determines a cause of particle adhesion to the substrate based on the evaluation data created by the evaluation data creating part and the correspondence data stored in the storage part.

The evaluation data may be created based on a comparison between an inspection result obtained before the substrate is subjected to a predetermined treatment by the semiconductor device manufacturing apparatus and an inspection result obtained after the substrate has been subjected to the treatment. Alternatively, the evaluation data may be created based only on an inspection result obtained after the treatment, without taking account of an inspection result obtained before the treatment. These options may be selected depending on a sort of treatment step performed before the predetermined treatment, for example.

In a typical embodiment, the particle detecting part is configured to output data, as the detection result, in which representative values each representing a state of particle adhesion in each minute areas (a square-shaped area 0.1 mm to 0.5 mm on a side, for example) defined by dividing a surface of the substrate are correlated with addresses of the respective minute areas. In the evaluation data, evaluation values, each representing the state of particle adhesion in each of evaluation areas defined by dividing a surface of the substrate, are correlated with addresses of the respective evaluation areas. The evaluation value in each of the evaluation areas is an output of a predetermined function that is obtained by applying the representative values of the plurality of minute areas included in the evaluation area to the function. In defining the evaluation areas on the surface of the substrate by dividing the same, the number of divided areas is preferably equal to or less than 100, more preferably equal to or less than 50. Since a size of the evaluation data is small, it is easy to transfer the evaluation data to another computer, or to execute a process for estimating a cause of particle adhesion based on the evaluation data.

Each of the evaluation values may be determined based on a size and/or the number of particles. Each of the evaluation values may be expressed as binarized data. The binarized data may be determined based on that fact that the number of particles detected by the particle detecting part is larger, or not larger than a predetermined reference value. The evaluation data creating part may be configured to create evaluation data with respect to only a part or parts of a surface of the substrate.

According to the present invention, it is possible to automatically make a diagnosis of the cause of particle adhesion, by using the correspondence data. The diagnostic result can be displayed in a display part. It is also possible to output a control signal to the semiconductor device manufacturing apparatus based on the diagnostic result.

### BRIEF DESCRIPTION OF THE DRAWINGS

Fig. 1 is a block diagram showing the whole structure of a semiconductor device manufacturing system in one embodiment of the present invention;
Fig. 2 is a block diagram showing the structure of a particle inspecting device shown in Fig. 1;
Fig. 3 is a chart showing evaluation areas, defined in a wafer, together with their addresses;
Fig. 4 is a chart schematically showing the structure of a correspondence table;
Fig. 5 shows pixel data and evaluation data created based on the pixel data in a form of two-dimensional map made based on the pixel and evaluation data;
Fig. 6 is a chart showing an example of an area in which particles are evaluated in an alternative embodiment;
Fig. 7 is a block diagram of an application of the semiconductor device manufacturing system shown in Fig. 1;
Fig. 8 is a longitudinal side view showing the structure of a heat treatment apparatus as an example of a semiconductor device manufacturing apparatus included in a semiconductor device manufacturing system;
Fig. 9 is a plan view of the heat treatment apparatus shown in Fig. 8;
Fig. 10 is a perspective view of a part of the heat treatment apparatus shown in Fig. 8;
Fig. 11 shows an example of pixel data and evaluation data created based on the pixel data in a form of two-dimensional map made based on the pixel and evaluation data obtained when a malfunction occurs in the heat treatment apparatus shown in Figs. 8 to 10;
Fig. 12 shows an alternative example of pixel data and evaluation data created based on the pixel data in a form of two-dimensional map made based on the pixel and evaluation data obtained when a malfunction occurs in the heat treatment apparatus shown in Figs. 8 to 10;
Fig. 13 is a schematic plan view showing the structure of an etching apparatus as an example of a semiconductor device manufacturing apparatus included in a semiconductor device manufacturing system;
Fig. 14 is a sectional view showing the structure of an etching unit included in the etching apparatus shown in Fig. 13;
Figs. 15 shows pixel data, each shown in a form of a schematic two-dimensional map, each of which is created based on pixel data obtained when a malfunction occurs in the etching apparatus shown in Fig. 14;
Fig. 16 is a schematic plan view showing a resist pattern forming apparatus as an example of a semiconductor device manufacturing apparatus included in a semiconductor device manufacturing apparatus;
Fig. 17 is a sectional view showing the structure of a coating unit included in the resist pattern forming apparatus shown in Fig. 16;
Fig. 18 is a sectional view showing the structure of a heating unit included in the resist pattern forming apparatus shown in Fig. 16;
Figs. 19 shows pixel data, each shown in a form of a schematic two-dimensional map, each of which is created based on pixel data obtained when a malfunction occurs in the coating unit shown in Fig. 17 and the heating unit shown in Fig. 18; and
Fig. 20 shows a graph of a particle frequency distribution provided by a particle inspecting device, and a particle map provided by the particle inspecting device.

### DESCRIPTION OF THE PREFERRED EMBODIMENTS

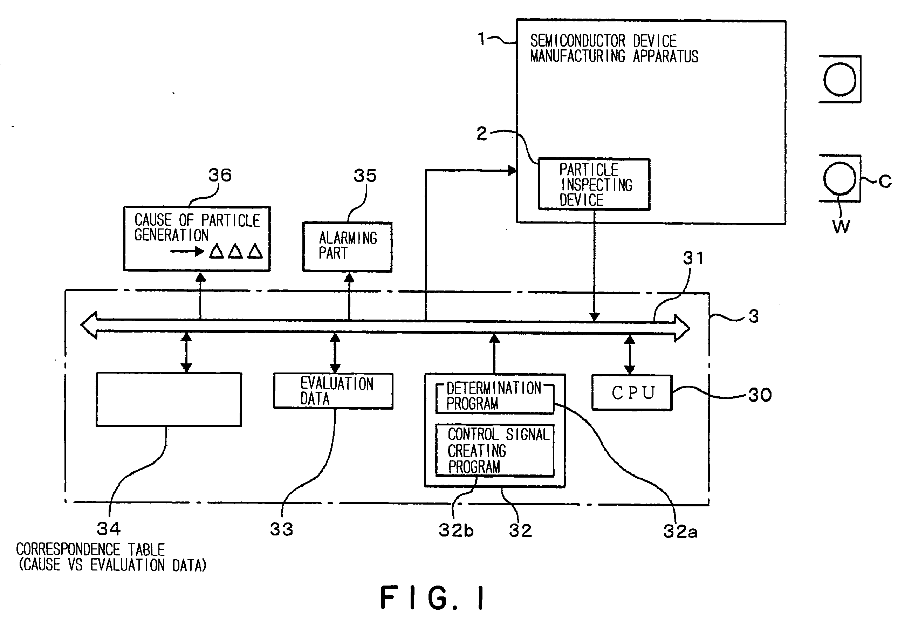

Fig. 1 is shows the structure of a semiconductor device manufacturing system in one embodiment of the present invention. The semiconductor device manufacturing system includes a semiconductor device manufacturing apparatus 1. The semiconductor device manufacturing apparatus 1 is a substrate processing apparatus that performs a treatment for forming a semiconductor integrated circuit on a substrate such as a semiconductor wafer or a glass substrate for a liquid crystal display. The semiconductor device manufacturing apparatus 1 may be a heat treatment apparatus, an etching apparatus, a film-deposition apparatus, a spattering apparatus, an ion implantation apparatus, an ashing apparatus, a coating and developing apparatus that applies a resist liquid on a substrate and develops the substrate after it is exposed, a cleaning apparatus, and so on. Not limited to the above apparatuses that directly treats a substrate, the semiconductor device manufacturing apparatus 1 may be other apparatuses used in semiconductor device manufacturing processes, for example, an inspecting apparatus that inspects a semiconductor integrated circuit formed on a substrate, and an apparatus that forms a resist pattern on a mask substrate (reticle substrate) which is used as a mask in a exposure process.

A carrier C containing plural unprocessed wafers W is loaded into the semiconductor device manufacturing apparatus 1. The wafers taken out from the carrier C are subjected to a predetermined treatment. Thereafter, the processed wafers W are returned to the carrier C, and unloaded from the semiconductor device manufacturing apparatus 1. In the semiconductor device manufacturing apparatus 1, there is arranged a particle inspecting device 2 that inspects particles adhered to the wafers W which have been processed by a predetermined treatment by the semiconductor device manufacturing apparatus 1.

In order to avoid misunderstanding, it is recommended to read again the meanings of the terms "pixel" and "pixel data" stated in the "Background Art" at the opening part of the specification.

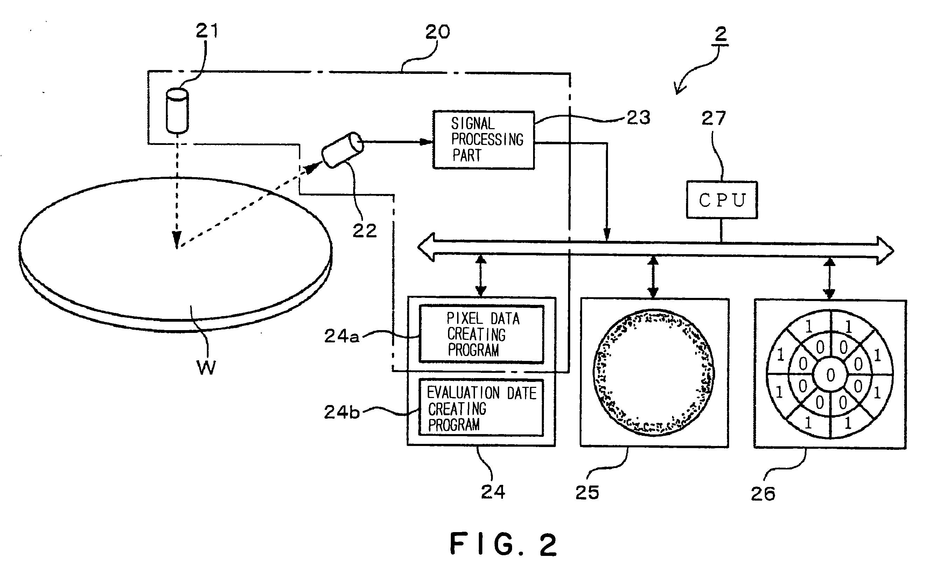

As shown in Fig. 2, the particle inspecting device 2 includes: a light irradiating part 21 that irradiates a leaser beam, the light irradiating part 21 facing a wafer W supported on a turntable, not shown, and being capable of moving in a radial direction of the wafer; a light receiving part 22 that receives a scattered light of the laser beam and generates a signal corresponding to the intensity of the scattered light; and a signal processing part 23 that processes the signal sent from the light receiving part 22. The signal processing part 23 is connected to a bus 23a, to which a program storage part 24, a pixel data storage part 25 storing pixel data, an evaluation data storage part 26 storing evaluation data, and a CPU (Central Processing Unit) 27 are connected. The program storage part 24 stores programs such as a pixel data creating program 24a and an evaluation data creating program 24b.

As stated in the above "Background Art", a spot size (beam diameter) of a laser beam irradiating the wafer W by the light irradiating part 21 is typically 60 µm in diameter. Pixels (i.e., minute areas) are defined by dividing the surface of a wafer into plural square-shaped areas (in more detail, sector areas) 0.1 mm to 0.5 mm on a side. Each pixel is entirely scanned by a laser beam (i.e., a pulsed laser beam), which is intermittently irradiating the pixel with the irradiating position being shifted by a predetermined amount, for example, half a spot size of the laser beam.

In order to shift the position irradiated with a laser beam, movement of the light irradiating part 21 in a radial direction of the wafer W and rotation of the wafer W are combined with each other. The pixels are scanned one by one, that is, after one pixel is entirely scanned, the next pixel is scanned, so that all the surface of the wafer can be scanned. Alternatively, a center of the wafer W may be scanned by irradiating a laser beam at first, and repeating the following steps (a) and (b) for each rotation of the wafer W, where the step (a) is a step of slightly moving the light irradiating part 21 radially outward the wafer W; and the step (b) is a step of irradiating a pulsed laser beam from the light irradiating part 21 with the radial position thereof being fixed, while intermittently rotating the wafer W. In this case, data obtained for each light irradiation is allotted to each pixel by a subsequent calculating process.

Every time when the position of the light irradiating part 21 is shifted relative to the wafer W, the light irradiating part 21 generates one pulse of laser beam, and the light receiving part 22 receives the laser beam scattered by the wafer surface and/or particles. The light receiving part 22 sends a voltage signal (i.e., detection signal) corresponding to the intensity of the received scattered light (intensity of a Raman scattered light) to the signal processing part 23.

The signal processing part 23 quantizes the voltage signal by means of an analog-digital converter, not shown. A quantization bit rate may be equal to or more than 2 bits, e.g., 8 bits (quantization level of 256 steps) when evaluating the particle size, or may be 1 bit (quantization level of 2 steps, binarized data) when evaluating only the existence of particles without evaluating the size thereof.

Since one pixel is irradiated with plural pulses of laser beam, plural data on the scattered light intensity are obtained for each pixel. The CPU 27 selects the maximum value of the scattered light intensity in each pixel as the representative value of the pixel. Then, the CPU 27 stores the data, as the pixel data, in which the representative values are correlated to the addresses of the respective pixels, in the pixel data storage part 25.

When the particle size is evaluated, the representative value of each pixel corresponds to the largest particle size in the pixel. In this case, the representative value of each pixel represents the existence of particles and the maximum particle size. When the particle size is not evaluated, the representative value of each pixel is expressed as binarized data only representing whether or not a particle exits in the pixel.

The rotation angle of the turntable and the radial position of the light irradiating part 21 can be easily detected by a known means. The wafer W has a part for alignment, such as a notch and an orientation flat, for showing the crystal direction of the wafer W. Thus, the address of each pixel can be specified in polar coordinates (r,θ) and/or X-Y orthogonal coordinates, on the basis of the alignment part. Fig. 2 shows a two-dimensional map which is created based on the pixel data stored in the pixel data storage part 25. According to the map, the distribution of the particles can be visually understood.

In this embodiment, a particle detecting part is constituted by the light irradiating part 21, the light receiving part 22, the signal processing part 23, and the pixel data creating program 24a.

Since the size of each pixel is minute, the total number of pixels is no fewer than some hundred thousands in a wafer having a diameter of 300 mm, and the pixel data size is enormous. When the analysis of the cause of particle adhesion is executed by using the vast amounts of data as they are, the processing unit bears a heavy burden. Thus, the processing unit must have a processing element having a high computing power, and a high-capacity memory. In order to avoid this situation, in this embodiment, the surface of the wafer is divided into areas (hereinafter referred to as "evaluation areas"). The size of each evaluation area is significantly larger than the size of the pixel. The analysis of the cause of generating particles is executed based on the representative value (hereinafter referred to as "evaluation value") representing the state of particle adhesion in each evaluation area. Herein, data in which evaluation values are correlated to the addresses of the respective evaluation areas is referred to as "evaluation data".

In order to achieve the foregoing function, the program storage part 24 in the particle inspecting device 2 stores the evaluation data creating program 24b. The CPU 27 converts the pixel data to the evaluation data by means of the program 24b. The evaluation data is stored in the evaluation data storage part 26.

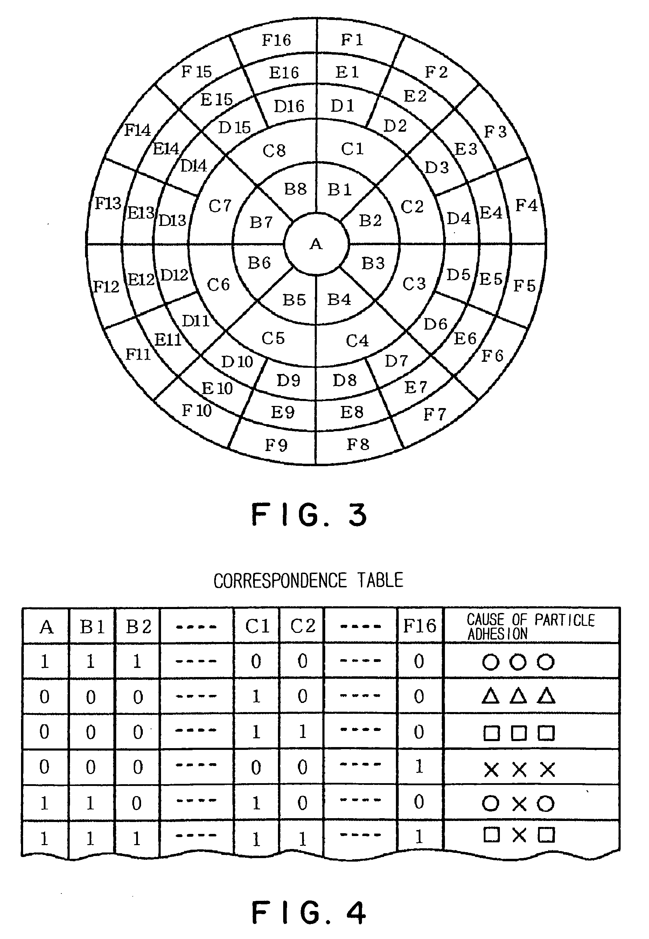

Fig. 3 shows how a surface (typically a surface on which a device is formed) of the wafer W is divided into plural evaluation areas, in one example. In the example shown in Fig. 3, the surface of the wafer W is concentrically divided into plural ring-shaped areas, each of which is further divided circumferentially into plural sector areas, so as to define plural evaluation areas. An alphabet and a numeric character described in each evaluation area (for example, A, Bl, B2, and F16) indicate the address thereof. The addresses are assigned to the respective evaluation areas, on the basis of the alignment part such as an orientation flat and a notch. Not limited to the example shown in Fig. 3, the number of divided areas of the surface of the wafer W and a dividing manner may be changed depending on the sort of the semiconductor device manufacturing apparatus 1, for example.

As will be understood from the description below, the present invention method can reduce the processing load which the processing unit may bear when analyzing the cause of particle adhesion based on vast amounts of pixel data as they are. Thus, the excessively large number of divided evaluation areas degrades the readiness of data processing. On the other hand, the excessively small number of divided evaluation areas makes it difficult to analyze the cause of particle adhesion. Taking these into consideration, the number of divided areas of the surface of the wafer W is preferably 100 or less, more preferably 50 or less, in order not to complicate the algorithm for adhesion cause analysis.

A method of converting the pixel data into the evaluation data will be described in detail below. Plural pixels are included in each evaluation area. In a case where the representative value of each pixel is binarized data which simply indicates the existence of particle (the particle size is disregarded), if there exists a particle in a pixel, the representative value of the pixel is "1"; and if there exists no particle, the representative value of the pixel is "0". In each evaluation area, if the number of pixels having representative value "1" surpasses a reference value (threshold value), the evaluation value of the evaluation area is "1". Meanwhile, if the number of pixels having representative value "1" does not reach the reference value, the evaluation value of the evaluation area is "0". That is, the evaluation value, which is the representative value of each evaluation area, is expressed as binarized data. The obtained evaluation values of the respective evaluation areas are stored in the evaluation data storage part 26 as evaluation data in which the evaluation values are correlated with addresses of the respective evaluation areas. Since the addresses of the respective pixels and the addresses of the respective evaluation areas are determined on the basis of an orientation flat or a notch, it is easy to identify the pixels included each evaluation area.

Practically, an allowable amount of particles adhere to the wafer W before it is treated in the semiconductor device manufacturing apparatus 1, in general. Thus, it is difficult to specify the particles adhering to the wafer W as a result of the treatment, based only on the particle data obtained after the treatment. Therefore, it is preferable to create evaluation data based on both particle data obtained before the treatment and particle data obtained after the treatment.

In this case, in place of the binarized data, representative values of the pixels before the treatment and representative values of the pixels after the treatment can be expressed as plural-bit data (e.g., data expressing the scattered light intensity at a quantization level of 256 steps, which is as described above). The difference between the representative value before the treatment and the representative value after the treatment in each pixel is calculated. Then, a representative value of the pixel for creating the evaluation data (hereinafter, referred to as "representative value for evaluation data creation") is determined based on the difference. The representative value for evaluation data creation can be expressed as binarized data. In a pixel, if the representative value after treatment is larger than the representative value before treatment, it is considered that new particle(s) is adhered to the pixel due to the treatment, and "1" is assigned to the pixel as the representative value for evaluation data creation. Otherwise, "0" is assigned to the pixel as the representative value for evaluation data creation.

The above data processing is executed by the pixel data creating program. Then, the determined representative values for evaluation data creation of the respective pixels are stored in the pixel data storage part 25 as pixel data in which the representative values of the pixels are correlated with the addresses of the respective pixels. The pixel data is converted into evaluation data in the same manner as described above.

The particle detection result before the treatment of the wafer W may be such that it is obtained through an inspection by a particle inspecting device incorporated in the semiconductor device manufacturing apparatus 1 after the wafer W is loaded into the apparatus 1, or through an inspection carried out before the wafer W is loaded into the apparatus 1.

Referring again to Fig. 1, the reference number 3 depicts a controlling part, which is an apparatus controller arranged in each semiconductor device manufacturing apparatus 1, and which controls the operation of the semiconductor device manufacturing apparatus 1. The controlling part 3 includes: a CPU (Central Processing Unit) 30; a first storage part 32 storing a determination program 32a and a control signal creating program 32b; a second storage part 33 storing evaluation data; and a third storage part 34 storing a correspondence table (see, Fig. 4) showing the correspondence between evaluation data and the cause of particle adhesion. The CPU 30, the first storage part 32, the second storage part 33, and the third storage part 34 are connected to each other via a bus 31 to which the particle inspecting device 2 is connected through an in/out port, not shown. In addition, an alarming part 35 and a display part 36 are connected to the bus 31.

Fig. 4 schematically shows the correspondence table. The correspondence table lists the relationship between causes of particle adhesion and evaluation data, which is made based on past experience and/or experiments. By applying evaluation data created based on the inspection to the correspondence table, the cause of particle adhesion can be identified.

Note that the relationship between evaluation data and the causes of particle adhesion need not have one-to-one correspondence. For example, when particles adhere to the peripheral portion of the wafer W by a certain cause, there may be one or more particle distribution patterns. Taking this into consideration, plural evaluation data may be assigned to one cause of particle adhesion, in the correspondence table. On the other hand, there may be a case in which a certain particle distribution is caused by plural causes of particle adhesion. Taking this into consideration, plural causes of particle adhesion may be assigned to one evaluation data, in the correspondence table.

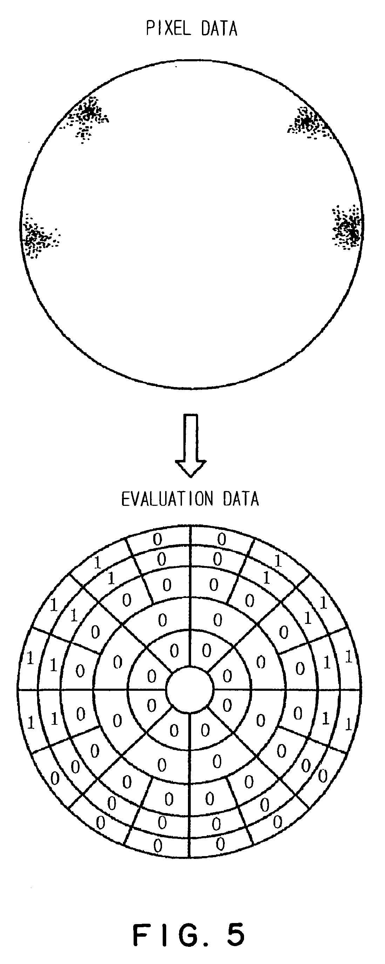

In the upper part of Fig. 5, pixel data are displayed in a two-dimensional map, the pixel data being obtained when a wafer W is treated in a vertical heat treatment apparatus, which will be described later, in which four struts of a wafer holder are contaminated. The map shows that particles adhere to portions of the wafer supported by the four struts, and adjacent parts to the portions. In the lower part of Fig. 5, evaluation data created based on the pixel data are displayed in a two-dimensional map. The map shows that evaluation value "1" is assigned to evaluation areas where the number of pixels to which representative value "1" is assigned is large, and evaluation value "0" is assigned to other evaluation areas.

The CPU 30 collates the measured evaluation data stored in the second storage part 33 with plural evaluation data recorded in the correspondence table stored in the third storage part 34, by means of the determination program 32a stored in the first storage part 32; selects, from the plural evaluation data in the correspondence table, one evaluation data corresponding to the measured evaluation data; and identifies the cause of particle adhesion corresponding to the selected evaluation data as the actual cause of particle adhesion. The CPU 30 may make the alarming part 35 generate an alarm; make the display part 36 display the cause of particle adhesion (cause of particle generation); and may generate a control signal corresponding to the cause by means of the control signal creating program 32b, and output the control signal.

The control signal is a command signal for commanding execution of a countermeasure against the particle adhesion. For example, if it is determined that the particle adhesion is caused by contamination of a wafer holder (see Fig. 5), the control signal may be such that it instructs to suspend the wafer treatment to be carried out next, and clean the wafer holder in the reaction vessel. The control signal may be a stop signal for stopping the operation of the apparatus.

The display part 36 is not limited to a display screen of an operation panel disposed at the main body of the semiconductor device manufacturing apparatus 1, but may be a printer or the like.

In the embodiment shown in Fig. 1, the CPU 30 and the determination program 32a constitute a determining part that determines the cause of particle adhesion based on measured evaluation data and the correspondence table. The particle inspecting device 2 and the controlling part 3 constitute a diagnosing apparatus for making a diagnosis of the cause of particle generation in the semiconductor device manufacturing apparatus 1.

The respective evaluation areas may have the same planar dimension. In this case, the reference value (i.e., the number of the pixels, having representative value "1", included in the evaluation area) for determining the evaluation value of the evaluation area may be the same for all the evaluation areas. In this case, if the number of particles existing in an evaluation area exceeds a reference value, evaluation value "1" is assigned to the evaluation area. Otherwise, evaluation value "0" is assigned thereto. Alternatively, the planer areas of the evaluation areas may be different. In this case, reference values for respective evaluation areas may be determined in proportion to the planer area of each evaluation area.

The evaluation value may be determined based not only on the number of the pixels having particle(s) included in the evaluation area, but also on the particle size. In this case, even if the number of pixels containing particle(s) included in an evaluation area is smaller than the reference value, but if the number of pixels containing a particle larger than a predetermined size is more than a predetermined value, evaluation value "1" may be assigned to the evaluation area. In this case, the representative value of each pixel is not binarized data, but has plural levels such as 256 levels.

The evaluation value of an evaluation area may be determined based only on the particle size, irrespective of the number of pixels containing particle(s) included in the evaluation area. In this case, if there exists, in an evaluation area, at least one pixel containing a particle larger than a predetermined size exists, evaluation value "1" may be assigned to the evaluation area; on the contrary, even if there exists many pixels containing particle(s), but if the size of the particles is smaller than a predetermined size, evaluation value "0" may be assigned to the evaluation area.

Not limited to binarized data, an evaluation value may be data having plural levels. For example, "20" and "40" are set as reference values of the number of pixels containing particle(s). In this case, if the number of pixels containing particle(s) included in an evaluation area is zero, evaluation value "0" may be assigned to the evaluation area; if the number of pixels containing particle(s) is not less than 1 but less than 20, evaluation value "1" may be assigned thereto; if the number of pixels containing particle(s) is not less than 20 but less than 40, evaluation value "2" may be assigned thereto; and if the number of pixels containing particle(s) is equal to or more than 40, an evaluation value "3" may be assigned thereto.

Both the particle size and the number of particles may be considered for determining the evaluation value having plural levels. For example, in an evaluation area, if there are less than 5 pixels each containing particle(s) whose maximum size is less than 3 µm, if there are less than 5 pixels each containing particle(s) whose maximum size is not less than 3 µm but less than 8 µm, and if there are less than 5 pixels each containing particle(s) whose maximum size equal to or more than 8 µm exists, evaluation value "1" may be assigned to the evaluation area; and if there are 5 or more pixels each containing particle(s) whose maximum size is less than 3 µm, if there are less than 5 pixels each containing particle(s) whose maximum size is not less than 3 µm but less than 8 µm, and if there are less than 5 pixels each containing particle(s) whose maximum size is equal to or more than 8 µm, evaluation value "2" may be assigned to the evaluation area.

As described above, various functions (converting rules) can be used for converting the pixel data to the evaluation data. Depending on the sort of the treatment, the function to be used can be suitably changed.

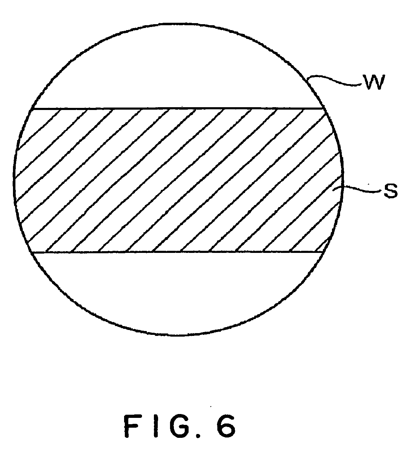

In place of defining evaluation areas in the entire surface of a wafer, evaluation areas may be defined only in a specific part(s) of the wafer surface. Fig. 6 shows an example in which evaluation areas are defined only in a strip-shaped zone S transversely extending across the center of the wafer W. If the evaluation areas are set in such a manner, it is possible to differentiate plural particle-adhering states including a state in which particles adhere only to the periphery of the wafer, a state in which particles adhere only to the central part of the wafer, and a state in which particles adhere to a part of the periphery of the wafer W (see Fig. 5). In this case, the data processing load is advantageously reduced due to the small size of the evaluation data.

Not limited to the front surface of a wafer (surface to be treated), particle detection may be performed with respect to the back surface of the wafer. In this case as well, similar to the operations for the front surface of the wafer, a detection result may be converted into pixel data, evaluation data can be created based on the pixel data, and the cause of particle adhesion can be estimated based on the evaluation data referring to the correspondence table.

Next, a series of steps performed in the semiconductor device manufacturing system shown in Fig. 1 will be described.

Wafers W are subjected to a predetermined treatment by the semiconductor device manufacturing system 1. In this treatment step, a monitor wafer contained in the carrier C together with product wafers is subjected to the same treatment as that for the product wafers. The monitor wafer is loaded into the particle inspecting device 2, and particles are detected with respect to the front surface, the back surface, or both front and back surfaces of the monitor wafer. The particle detection result of the monitor wafer is stored in the pixel data storage part 25 of the particle inspecting device 2 in the pixel data format. The CPU 30 creates evaluation data based on the pixel data by means of the evaluation data creating program 24b. The created evaluation data are stored in the evaluation data storage part 26.

Pixel data, based on which evaluation data are created, may be created based only on a detection result of the monitor wafer after treatment. Alternatively, the pixel data may be created based on a comparison between pixel data created based on a detection result of the monitor wafer after treatment and that before treatment. The thus created evaluation data are sent from the particle inspecting device 2 to the second storage part 33 of the controlling part 3.

Subsequently, the CPU 30 collates the created evaluation data with the evaluation data recorded in the correspondence table stored in the third storage part 34, by using the determination program 32a. When the correspondence table has no evaluation data corresponding to the created evaluation data, it is determined to be "normal". Then, the operation of the semiconductor device manufacturing apparatus 1 is continued as it is.

On the other hand, when the correspondence table has evaluation data corresponding to the created evaluation data, the cause of particle adhesion corresponding to the evaluation data is read out from the correspondence table. Then, the CPU 30 makes the alarming part 35 generate an alarm, while making the display part 36 display the specified cause of particle adhesion. In addition, the CPU 30 outputs, to the semiconductor device manufacturing apparatus 1, a control signal such as cleaning command and a command for stopping the operation of the apparatus, which is generated by using the control signal creating program 32b. An operator learns from the alarm of abnormal particle generation, and understands the cause of particle adhesion (generation) by looking at the display part 36.

For example, when the semiconductor device manufacturing apparatus 1 automatically perform a treatment for eliminating the cause of particle adhesion (e.g., cleaning the interior of the reaction vessel) based on the control signal, there is no need for the operator to perform a special operation. When the particle detection is carried out with respect to both front and back surfaces of the wafer, correspondence tables for the front surface and the back surface are respectively prepared in the third storage part 34. In the above embodiment, although particles only on the monitor wafer are detected, the present invention is not limited thereto. The particle detection may be performed not only to the monitor wafer but also to the product wafer(s), so as to determine occurrence of an abnormal condition based on the detection result. The particle detection may be performed only to the product wafer(s) so as to determine occurrence of an abnormal condition.

In the above embodiment, the cause of particle adhesion is determined by using the correspondence table that shows a relationship between evaluation data and causes of particle adhesion. Thus, the cause of particle adhesion can be rapidly, accurately identified, and hence a burden loaded on an operator can be reduced. A high skill is required for determining the cause of particle adhesion from an adhesion state of particles. However, according to the present embodiment, if a highly skilled operator is not available, it is easy to take a measure for eliminating the cause of particle adhesion.

In the above embodiment, the cause of adhesion of particles is not determined based on pixel data as they are, but is determined based on evaluation data created based on the pixel data. Since evaluation data are an aggregation of evaluation values, each being a single value, obtained by applying plural representative values of pixels to a predetermined function, the size of the evaluation data is significantly smaller than that of pixel data.

Therefore, a time required for transferring data (i.e., evaluation data) from the particle inspecting device 2 to means for determining the cause of particle adhesion (i.e., the controlling part 3, or the apparatus controller, in this embodiment) can be reduced. It is not necessary for the controlling part 3 to be provided with a high-capacity memory. Further, an estimation process for estimating the cause of particle adhesion can be executed rapidly. Uniform management of plural semiconductor device manufacturing apparatuses is possible, by automatically sending, to a central control computer, particle generation records of the respective semiconductor device manufacturing apparatuses together with causes of particle generation. The control signal generated based on the estimation result of the cause of particle adhesion may be a command signal for changing treatment parameters.

In the above embodiment, the particle inspecting device 2 is arranged in the semiconductor device manufacturing apparatus 1; and a wafer can be conveyed by a wafer conveying means (arm) arranged in the semiconductor device manufacturing apparatus 1 into the particle inspecting device 2. However, the particle inspecting device 2 may be of a stand-alone type, which is arranged separately from the semiconductor device manufacturing apparatus 1. Although some of the above-described advantages cannot be achieved, pixel data may be converted into evaluation data by means of an evaluation data creating program stored in the controlling part 3, after the pixel data is sent to the controlling part 3.

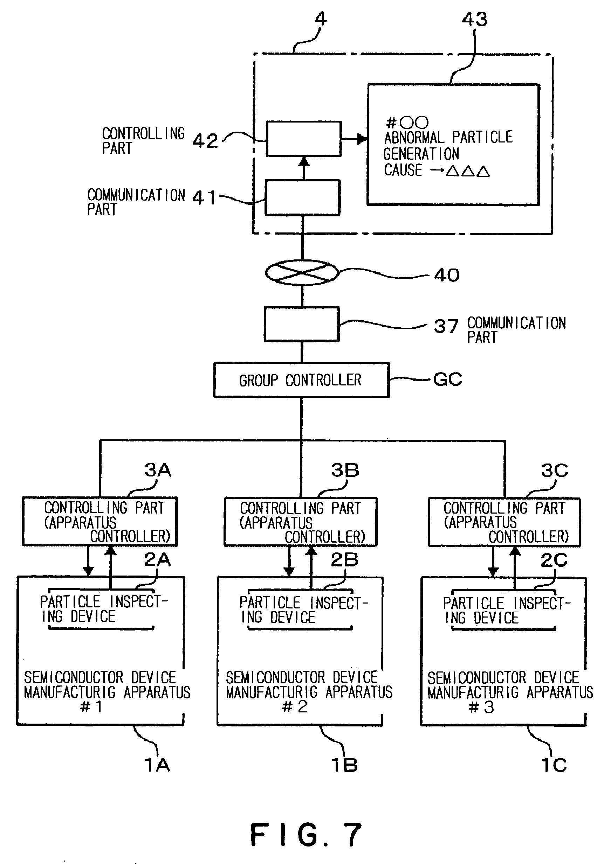

Fig. 7 is a diagram showing an application of the present invention. A semiconductor device manufacturing system shown in Fig. 7 includes: a plurality of, e.g., first to third semiconductor device manufacturing apparatuses 1A to 1C; particle inspecting devices 2A to 2C respectively disposed in the semiconductor device manufacturing apparatuses 1A to 1C; controlling parts (apparatus controllers) 3A to 3C respectively connected to the particle inspecting devices 2A to 2C; a group controller GC connected to the controlling part 3A to 3C to control the respective semiconductor device manufacturing apparatuses 1A to 1C; and a communication part 37 connected to the group controller GC. These constituent elements 1A to 1C, 2A to 2C, 3A to 3C, GC, and 37 are provided on the user's side, typically in a semiconductor device manufacturing factory.

The particle inspecting devices 2A to 2C correspond to the foregoing particle inspecting device 2, while the controllers 3A to 3C correspond to the foregoing controlling part 3. Preferably, the first storage part 32 for storing the determination program 32a and the control signal creating program 32b, the second storage part 33 for storing evaluation data, and the third storage part 34 for storing the correspondence table, all of which are shown in Fig. 1, are separated from the controlling parts 3A to 3C, and are arranged in the group controller GC. In this case, evaluation data obtained by the particle inspecting devices 2A to 2C are sent to the group controller GC respectively through the controlling parts 3A to 3C; and control signals generated by the group controller GC are sent to the respective semiconductor device manufacturing apparatuses 1A to 1C through the controlling parts 3A to 3C.

The communication part 37 is connected to a monitoring station 4 arranged on the apparatus manufacturer's side through a communication network 40 such as telephone lines and internet connections. The monitoring station 4 includes: a communication part 41; a controlling part 42 consisting of a computer; and a display part 43. When the group controller GC arranged on the user's side recognizes particle adhesion of a critical level and determines the cause thereof, information relating to the cause is sent from the communication part 37 to the controlling part 42 on the manufacturer's side through the communication network 40. The display part 43 displays the serial number of the semiconductor device manufacturing apparatus in an abnormal condition, and information relating to the cause of particle adhesion in the manufacturing apparatus. Note that the term "manufacturer" includes not only the manufacturer itself, but also a company to which the manufacturer entrusts maintenance work for the user.

By establishing the system that is capable of sending the cause of particle generation to the manufacturer, a service person of the manufacturer can prepare repair instruments required for eliminating the cause before visiting the user, so that the prompt response to the cause is possible.

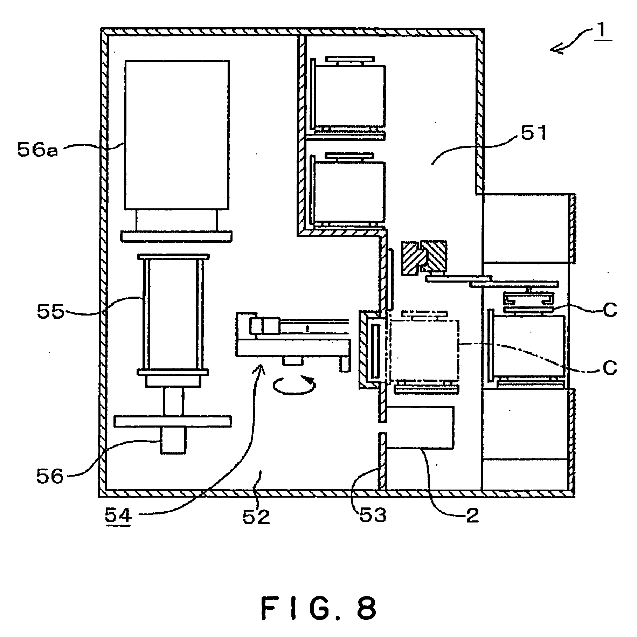

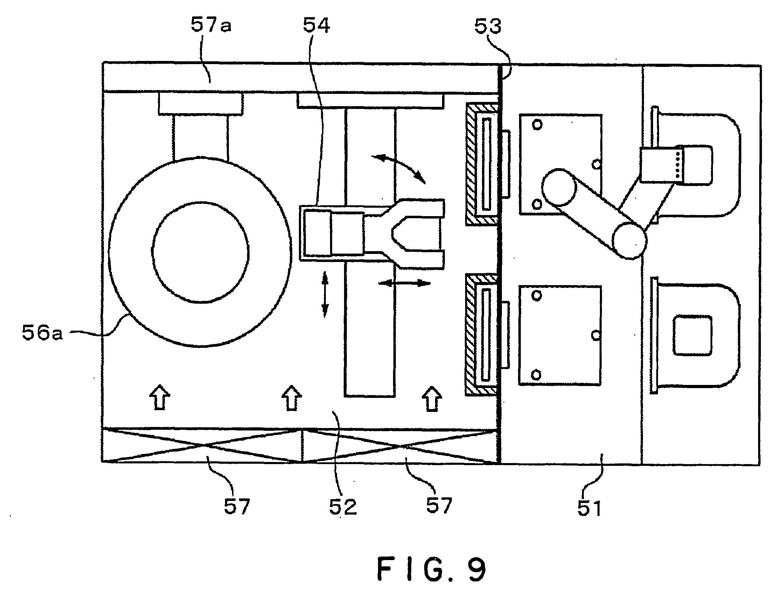

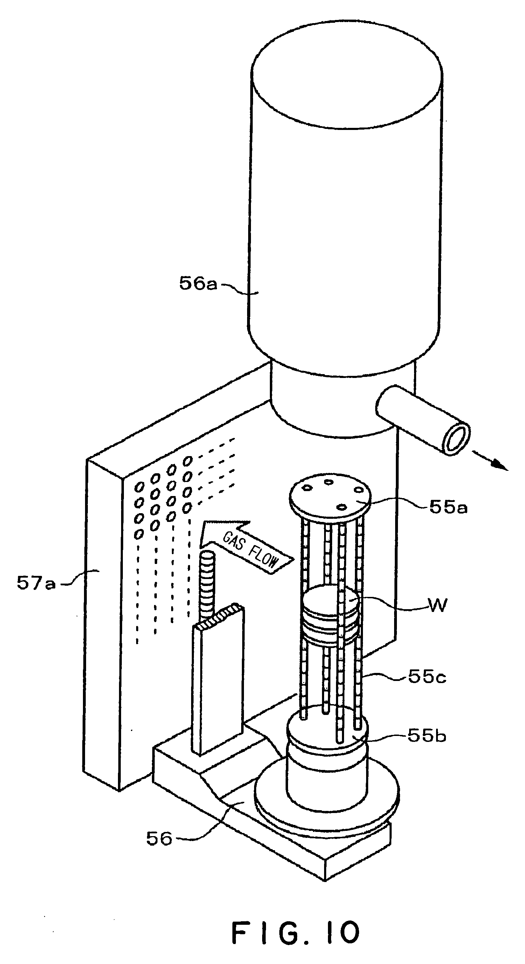

Concrete examples of a cause of adhesion of particles in a semiconductor device manufacturing apparatus are explained hereinbelow. Figs. 8 to 10 show a vertical heat treatment apparatus serving as a semiconductor device manufacturing apparatus. The reference number 51 depicts a loading area into which a sealable carrier C is loaded, the reference number 52 depicts a transfer area, and the reference number 53 depicts a partition wall separating the areas 51 and 52 from each other. The loading area 51 is filled with an atmosphere of air, while the transfer area 52 is filled with an atmosphere (e.g., an inert gas atmosphere) of higher cleanness than the atmosphere in the loading area 51. When the carrier C is loaded into the loading area 51, a lid of the carrier C is opened, and wafers in the carrier C is conveyed therefrom by a wafer transfer mechanism 54 to a wafer boat 55 (i.e., a substrate holder). Thereafter, the wafer boat 55 is loaded into a heat treatment furnace 56a by an elevating mechanism 56, so that the wafers are subjected to a heat treatment. An inert gas circulating through a filter unit 57 and a suction panel 57a flows across the transfer area 52. A particle inspecting device 2 is hermetically connected to the partition wall 53 in the loading area 51. The interior of the particle inspecting device 2 is opened to the transfer area 52. Inside the particle inspecting device 2, particles on a monitor wafer and/or product wafer(s) are detected before and after the heat treatment of the wafers. The wafer boat 55 has four struts 55c extending between a top plate 55a and a base plate 55b. Each strut 55c is provided with grooves each for supporting the periphery of a wafer.

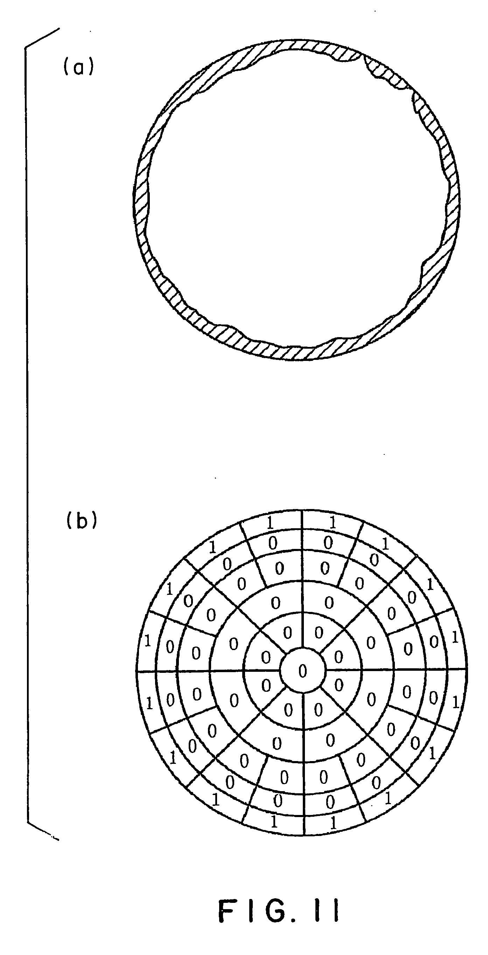

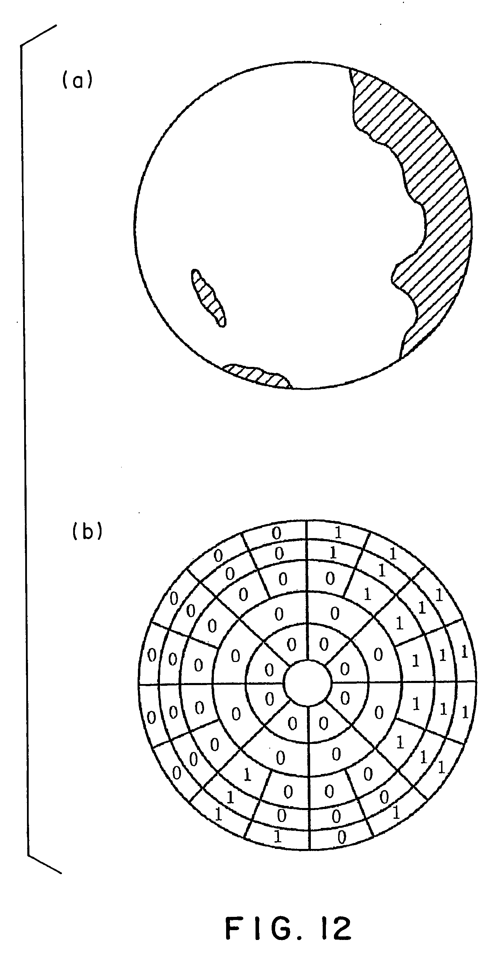

If all the four struts 55c of the wafer boat 55 are contaminated, pixel data and evaluation data created based on the result of detection of particles on the wafer surface are similar to those shown in Fig. 5. If particles are scattered from the inlet of an exhaust tube over a treatment area, particles adhere to the periphery of the wafer W. Thus, pixel data and evaluation data as shown in Figs. 11(a) and 11(b) are obtained. If the filter unit 57 is dusty, particles adhere to one side of the wafer. Thus, pixel data and evaluation data as shown in Figs. 12(a) and 12(b) are obtained. In Figs. 11 and 12, a part or parts to which particles adhere are shown by hatching the same, for simplification of the drawings.

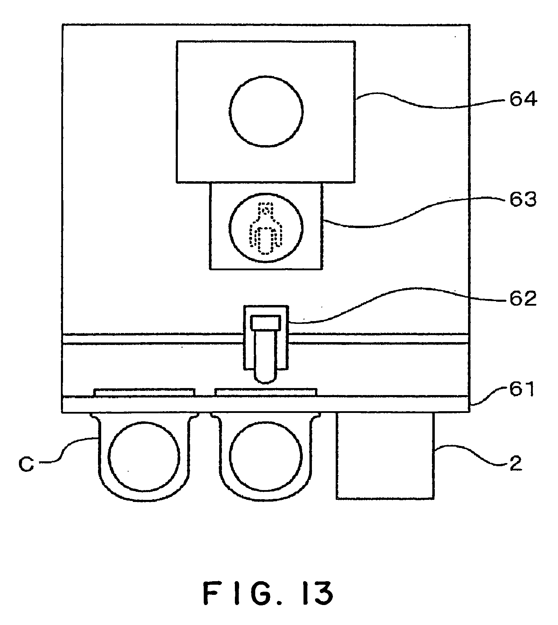

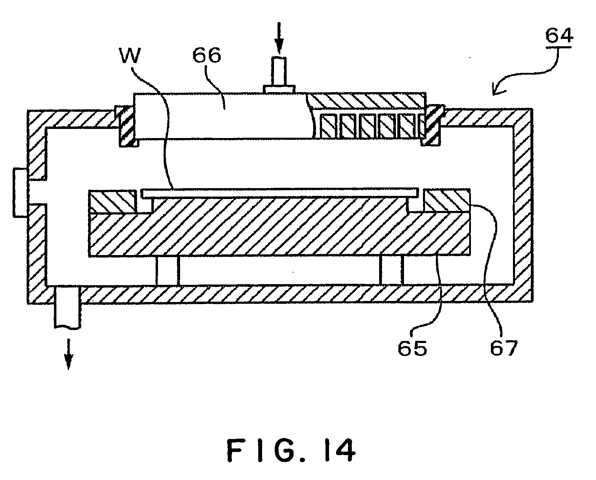

Another example is explained. Fig. 13 shows an etching apparatus (etcher). If a sealable cassette C is connected to a front surface of a front panel 61 of an apparatus main body which is substantially hermetically formed, the lid of the cassette C is opened. A wafer in the cassette C is taken out therefrom by a wafer conveying mechanism 62, and conveyed by a wafer conveying arm arranged in a load lock chamber 63 so as to be supported on a support table 65 disposed in an etching unit 64 shown in Fig. 14. A focus ring 67 is arranged around the support table 65. A gas showerhead 66 for supplying an etching gas is arranged above the support table 65. The particle inspecting device 2 is arranged in front of the front panel 61, and the interior of the particle inspecting device 2 is opened to the apparatus main body.

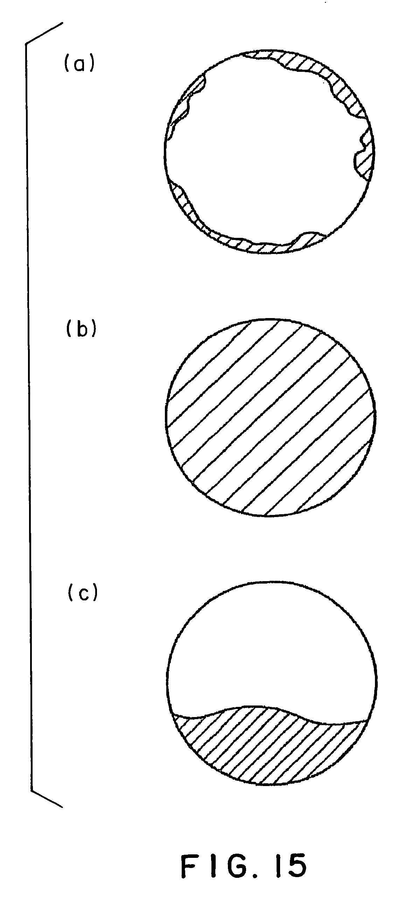

If the focus ring 67 is contaminated, particles adhere to the periphery of the wafer, and pixel data as shown in Fig. 15(a) is obtained. If the gas showerhead 66 is contaminated, particles adhere to substantially the entire surface of the wafer, and pixel data as shown in Fig. 15(b) is obtained. If particles are scattered over the treatment area from one of two exhaust tubes which are arranged to sandwich the support table 65 therebetween in a diametrical direction of the support table 65, particles adhere to one side of the surface of the wafer, and pixel data as shown in Fig. 15(c) is obtained.

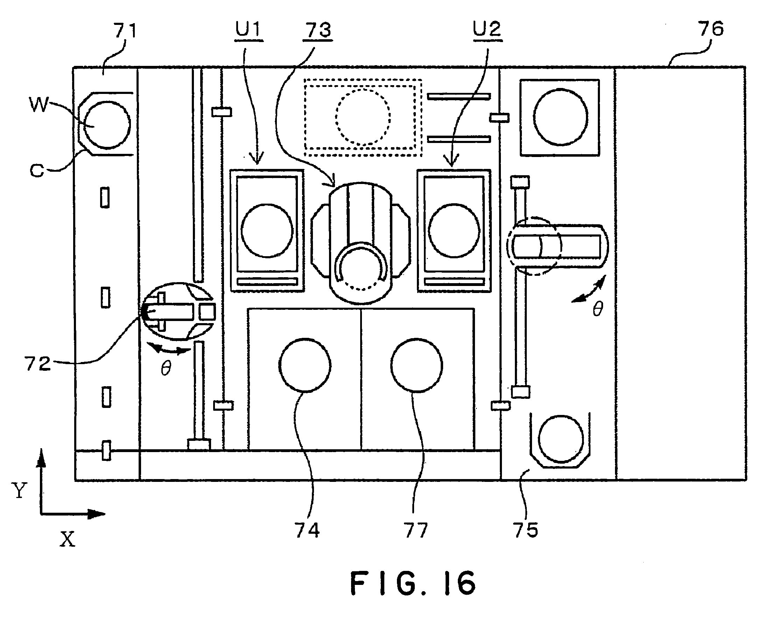

Another example is explained. Fig. 16 shows a coating and developing apparatus for applying a resist to a wafer and developing the surface of the wafer after exposure. The wafer is taken out from an open cassette C loaded in a cassette station 71 by a delivery arm 72. The wafer is delivered to a main arm 73 of a horseshoe shape through one of units included in a unit tower U1, the units being stacked in multistage. Thereafter, the wafer is transferred to an interface block 75 via a resist coating unit 74 and a heating unit in the unit tower U1 or U2, and then loaded into an exposing unit 76. After the wafer is exposed in the exposing unit 76, the wafer is loaded into a developing unit 77 through the interface block 75, and is developed in the developing unit 77.

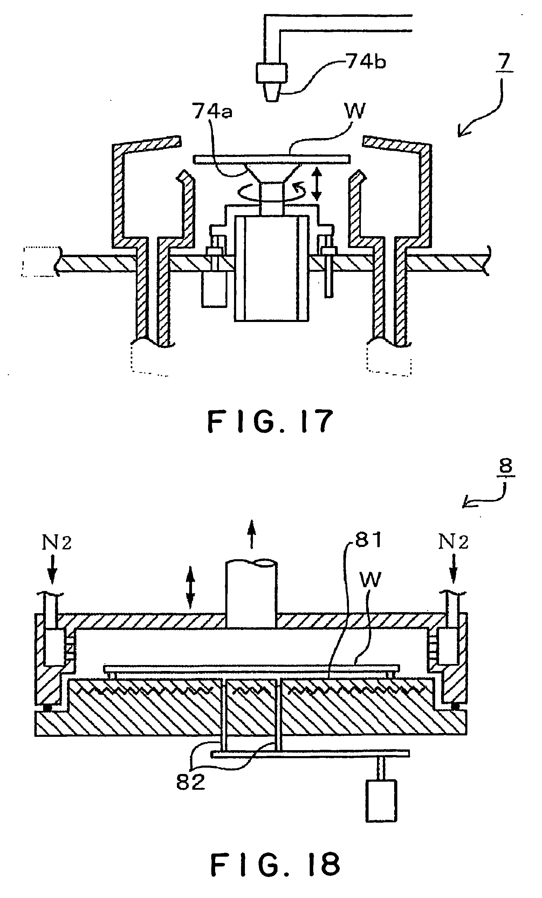

As shown in Fig. 17, in the resist coating unit 74, a resist liquid supplied from a nozzle 74b is applied to the surface of the wafer W, while a spin chuck 74a holds the wafer W by vacuuming and rotates at a high rotation speed. As shown in Fig. 18, in a heating unit 8, the wafer W is transferred from the main arm 73 to a heating plate 81 through three elevating pins 82 in the heating plate 81.

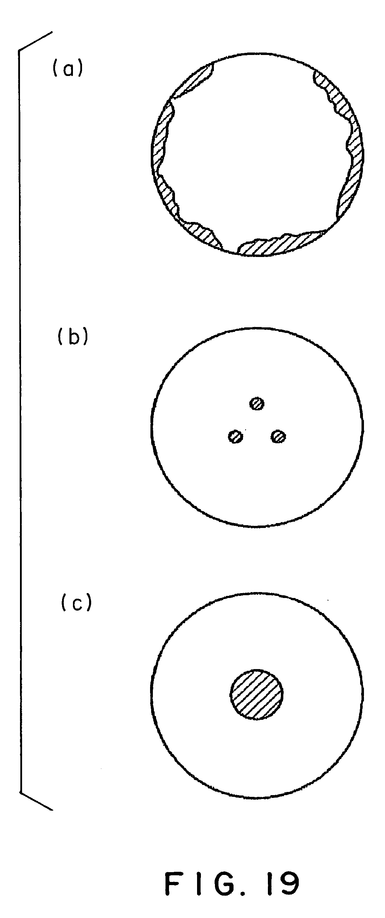

If the main arm 73 is contaminated, particles adhere to the periphery of the back surface of the wafer in a form of a horseshoe shape, and pixel data as shown in Fig. 19(a) is obtained. If the elevating pins 82 are contaminated, particles adhere to the back surface of the wafer in areas corresponding to heads of the elevating pins 82, and pixel data as shown in Fig. 19(b) is obtained. If the spin chuck 74a is contaminated, particles adhere to the back surface of the wafer in areas in contact with the spin chuck 74a, and the pixel data as shown in Fig. 19(c) is obtained.

## Claims

1. A semiconductor device manufacturing system, comprising:
a semiconductor device manufacturing apparatus;
a particle detecting part that detects particles adhered to a substrate which has been subjected to a predetermined treatment by the semiconductor device manufacturing apparatus;
an evaluation data creating part that creates evaluation data for evaluating a state of particle adhesion based on a detection result of the particle detecting part;
a storage part that stores previously created correspondence data relating to a correspondence between the evaluation data and causes of particle adhesion to the substrate; and
a determining part that determines a cause of particle adhesion to the substrate based on the evaluation data created by the evaluation data creating part and the correspondence data stored in the storage part.

2. The semiconductor device manufacturing system according to claim 1, wherein:
the particle detecting part is configured to output, as the detection result, data in which representative values each representing a state of particle adhesion in each of detection unit areas are correlated to addresses of the respective detection unit areas, the detection unit areas being defined by dividing a surface of the substrate;
the evaluation data is data in which evaluation values each representing the state of particle adhesion in each of evaluation areas are correlated with addresses of the respective evaluation areas, the evaluation areas being defined by dividing a surface of the substrate; and
each of the evaluation areas includes a plurality of detection unit areas, and each of the evaluation values is an output of a function to which the representative values of the plurality of detection unit areas included in the evaluation area are applied.

3. The semiconductor device manufacturing system according to claim 2, wherein
each of the evaluation values corresponds to a size and/or the number of particles existing in the detection unit areas included in the evaluation area.

4. The semiconductor device manufacturing system according to claim 2, wherein
each of the evaluation values is expressed as binarized data.

5. The semiconductor device manufacturing system according to claim 4, wherein
each of the evaluation values expressed as binarized data is determined based on a fact that the number of particles existing in the detection unit areas included in the evaluation area is larger, or not larger than a predetermined reference value.

6. The semiconductor device manufacturing system according to claim 1, wherein
the evaluation data creating part is configured to create evaluation data with respect to only a part or parts of a surface of the substrate.

7. The semiconductor device manufacturing system according to claim 1, wherein
the evaluation data creating part is configured to create evaluation data based on a comparison between a detection result obtained before a substrate is subjected to a predetermined treatment by the semiconductor device manufacturing apparatus, and a detection result obtained after the substrate has been subjected to the predetermined treatment.

8. The semiconductor device manufacturing system according to claim 1, further comprising:
a display part that displays the cause of particle adhesion to the substrate determined by the determining part.

9. The semiconductor device manufacturing system according to claim 1, further comprising:
means for outputting a control signal to the semiconductor device manufacturing apparatus based on the cause of particle adhesion to the substrate determined by the determining part.

10. The semiconductor device manufacturing system according to claim 1, comprising:
a particle inspecting device that inspects particles on a substrate; and
a controlling part arranged separately from the particle inspecting device to control the semiconductor device manufacturing apparatus;
wherein:
the particle detecting part and the evaluation data creating part are arranged in the particle inspecting device; and
the storage part and the determining part are arranged in the controlling part.

11. The semiconductor device manufacturing system according to claim 1, further comprising a communicating part that sends the cause of particle adhesion to the substrate determined by the determination part to a monitoring station through a communication line.
